Europäisches Patentamt

European Patent Office

Office européen des brevets

(11) Veröffentlichungsnummer : **0 205 649**
**B1**

(12) **EUROPÄISCHE PATENTSCHRIFT**

(45) Veröffentlichungstag der Patentschrift :
28.09.88

(51) Int. Cl.⁴ : **H 03 K 19/094, H 03 K 5/24**

(21) Anmeldenummer : 85108065.5

(22) Anmeldetag : 28.06.85

(54) In CMOS-Technik realisierter Inverter.

(43) Veröffentlichungstag der Anmeldung :
30.12.86 Patentblatt 86/52

(45) Bekanntmachung des Hinweises auf die Patenterteilung : 28.09.88 Patentblatt 88/39

(84) Benannte Vertragsstaaten :
DE FR NL

(56) Entgegenhaltungen :
WO-A-83 /007 85
DE-B- 2 639 598
DE-B- 2 757 464
DE-B- 2 811 074
DE-B- 3 008 280
US-A- 4 004 158
US-A- 4 394 587
US-A- 4 511 810

(73) Patentinhaber : Deutsche ITT Industries GmbH
Hans-Bunte-Strasse 19 Postfach 840
D-7800 Freiburg (DE)

(72) Erfinder : Gollinger, Wolfgang, Dipl.-Ing.
Reinhold-Schneider-Strasse 18a
D-7803 Gundelfingen (DE)

(74) Vertreter : Morstadt, Volker, Dipl.-Ing.
c/o Deutsche ITT Industries GmbH Patent/Lizenzab-
teilung Postfach 840 Hans-Bunte-Strasse 19
D-7800 Freiburg/Brsg. (DE)

**·Beschreibung**

Die Erfindung betrifft einen in CMOS-Technik, d. h. also in der Technik komplementärer Isolierschicht-Feldeffekttransistoren, realisierten Inverter mit zwei Transistoren, nämlich einen p-Kanal- und einem n-Kanal-Transistor, wobei deren gesteuerte Strompfade zwischen dem positiven und dem negativen Pol einer Betriebspannungsquelle in Serie liegen und deren gemeinsamer Verbindungspunkt den Inverterausgang bildet, das Gate des n-Kanal-Transistors über einen ersten Kondensator mit dem Invertereingang verbunden ist und der n-Kanal-Transistor der Ausgangstransistor eines ersten Stromspiegels ist, vergl. den Oberbegriff des Anspruchs 1.

Ein derartiger Inverter ist in der DE-A 30 08 280, insbesondere in Verbindung mit Fig. 2 beschrieben. Zusätzlich zu den erwähnten Merkmalen des Oberbegriffs des Anspruchs 1 ist beim vorbeschriebenen Inverter das Gate des p-Kanal-Transistors direkt mit dem Invertereingang und über einen hochohmigen Widerstand mit dem Inverterausgang verbunden.

Beim vorbeschriebenen Inverter ist der Gleichstromarbeitspunkt beider Transistoren bei kapazitiver Ankopplung des Eingangssignals fest eingestellt. Daher ist die untere Grenzfrequenz durch die Zeitkonstante der Kapazitiven Ankopplung festgelegt. Ferner nimmt er nach einem Impulsdurchlauf den bei etwa der halben Betriebsspannung liegenden Ausgangszustand an, wenn nicht innerhalb der durch die Zeitkonstante gegebenen Zeit eine weitere Impulsflanke folgt. Der vorbeschriebene Inverter hat somit keinen dauernd dem gerade durchgelaufenen Eingangssignal entsprechenden stabilen Ausgangspegel.

Die Aufgabe der in den Ansprüchen gekennzeichneten Erfindung besteht daher darin, den vorbeschriebenen Inverter so zu verbessern, daß einerseits die untere Grenzfrequenz für Eingangssignale ohne Erhöhung von Widerstands- und/oder Kapazitätswerten erniedrigt ist und andererseits die Schaltzeiten bei hohen Frequenzen nicht erhöht sind und daß ferner auch ohne Eingangssignale einer der beiden Binärpegel am Ausgang dauernd vorhanden ist.

Dadurch ergibt sich als Vorteil, daß sowohl bei Vorderals auch Rückflanken eines Eingangssignals die Steilheit der Ausgangsimpulsflanken entsprechend symmetrisch ist, so daß die Signallaufzeiten innerhalb des Inverters bei steigenden und fallenden Flanken möglichst gleich sind.

Der Inverter nach der Erfindung läßt sich vorteilhaft als Ausgangsstufe eines Spannungskomparator-Differenzverstärkers verwenden, da auch bei unterschiedlichen Spannungsdifferenzen an den Komparatoreingängen Unterschiede in den Signallaufzeiten bei steigenden und fallenden Impulsflanken sehr klein sind.

Es sei noch erwähnt, daß es bei der Verwendung von CMOS-Invertern als Kleinsignalverstärkern aus der DE-B-26 39 598 an sich bekannt ist, jedem der beiden Invertertransistoren über einen Kondensator das Eingangssignal zuzuführen. Die Erfindung beschäftigt sich demgegenüber mit der Verbesserung des Schaltverhaltens von CMOS-Invertern als Invertern für Digitalsignale.

Die Erfindung wird nun anhand der Figuren der Zeichnung näher erläutert.

Fig. 1   zeigt das Schaltbild eines Ausführungsbeispiels der Erfindung, und

Fig. 2   zeigt das Schaltbild der erwähnten Verwendung zusammen mit einem Spannungskomparator-Differenz-verstärker.

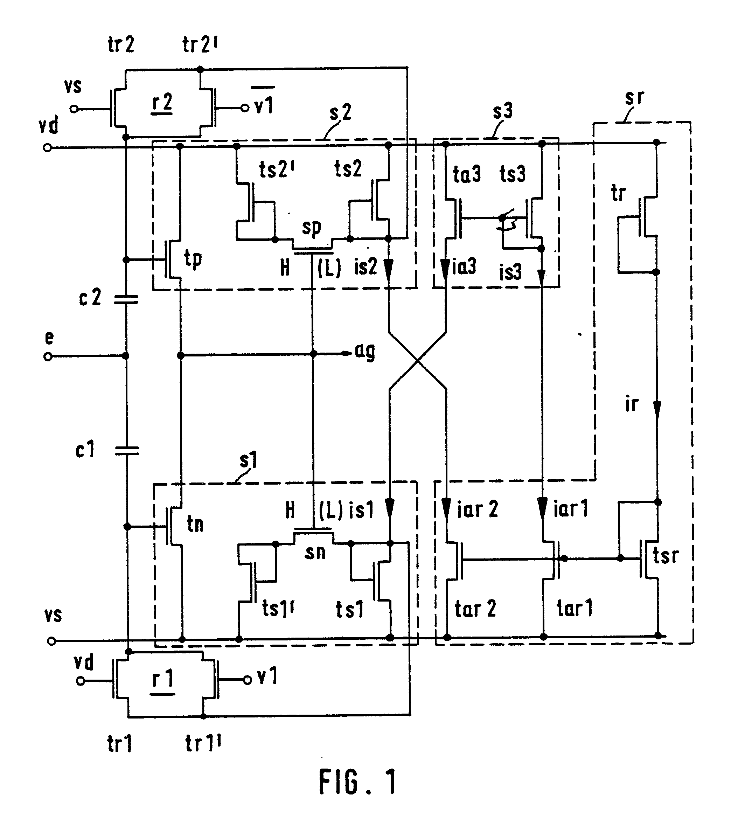

Nach Fig. 1 ist der Inverter mit den beiden Transistoren tp, tn, nämlich dem p-Kanal-Transistor tp und dem n-Kanal-Transistor tn, zwischen dem positiven Pol vd und dem negativen Pol vs der Betriebsspannungsquelle hinsichtlich der Serienschaltung der gesteuerten Strompfade der beiden Transistoren angeordnet. Zwischen dem Invertereingang e und dem jeweiligen Gate der beiden Transistoren liegt der erste bzw. zweite Kondensator c1, c2, so daß auch der p-Kanal-Transistor nur kapazitiv angesteuert ist.

Der Arbeitspunkteinstellung der beiden Transistoren tp, tn dienen der erste, zweite und dritte Stromspiegel s1, s2, s3 sowie der Referenzstromspiegel sr. Dabei sind der erste und der zweite Stromspiegel s1, s2 vom Ausgangssignal des Inverters zwischen einem hohen und einem niedrigen Stromwert umschaltbare Stromspiegel. Diese Umschaltung erfolgt derart, daß bei eiem H-Pegel am Inverterausgang ag der erste Stromspiegel den niedrigen und der zweite Stromspiegel den hohen Stromwert führen kann, während sich diese Verhältnisse bei einem L-Pegel gerade umkehren. Im statischen Zustand fließt zwar im Inverter nur der niedrige Stromwert, jedoch ist der zur Führung des hohen Stromwertes geschaltete Stromspiegel dadurch in der Lage, bei einem Eingangssignalsprung den nötigen Umladestrom zu liefern.

Durch die Umschaltung zwischen dem hohen und dem niedrigen Stromwert wird erreicht, daß der von einer Eingangssignalflanke bewirkte Ausgangspegel unabhängig von der Dauer bis zur nächsten Signalflanke erhalten bleibt und somit auch recht niederfrequente Eingangssignale zugelassen sind.

Die Umschaltung zwischen dem hohen und dem niedrigen Stromwert erfolgt im Schaltbild nach Fig. 1 dadurch, daß zwei hinsichtlich ihres Kanal-Längen/Breiten-Verhältnisses (= W/L-Verhältnis) z. B. gleichartig bemessene Transistoren in jedem Stromspiegel über einen mit dem Gate am Inverterausgang ag liegenden Schalttransistor sp, sn verbunden sind. Da bekanntlich in Stromspiegeln das Verhältnis zwischen Steuerstrom und Ausgangsstrom gleich dem Verhältnis der W/L-Verhältnisse von Steuer- une Ausgangstransistor ist, sind die Stromspiegel s1, s2 dann auf niedrigen Stromwert geschaltet, wenn der entsprechende Schalttransistor sp, sn leitend gesteuert und somit die beiden Steuertransistoren

in jedem Stromspiegel einander parallelgeschaltet sind. Der hohe Stromwert fließt demzufolge dann, wenn die Schalttransistoren gesperrt gesteuert sind. Wie bei Stromspiegeln ferner üblich, ist das Gate des Steuertransistors mit der zugehörigen Source direkt verbunden.

Der Steuerstrom is1 des ersten Stromspiegels s1 ist der Ausgangsstrom ia3 des dritten Stromspiegels s3 und dessen Steuerstrom is3 der erste Ausgangsstrom iar1 des Referenzstromspiegels sr. Der Steuerstrom is2 des zweiten Stromspiegels s2 ist der zweite Ausgangsstrom iar2 des Referenzstromspiegels sr. Der Referenzstrom ir ist dabei über den als Widerstand geschalteten Transistors tr bemeßbar. Der Summenpunkt des Referenzstromspiegels sr liegt am Pol vs und der Summenpunkt des dritten Stromspiegels s3 liegt am Pol vd der Betriebsspannungsquelle.

Die Steuerströme fließen dabei in den Steuertransistoren ts1, ts1', ts2, ts2', ts3, tsr und die Ausgangsströme in den Ausgangstransistoren ta3, tar1, tar2, tp, tn.

Bei einer bevorzugten Ausführungsform sind die W/L-Verhältnisse sämtlicher Stromspiegeltransistoren so bemessen, daß der hohe Stromwert des ersten Stromspiegels s1 gleich dem Doppelten seines niedrigen Stromwertes ist und daß alle Ströme der übrigen Stromspiegel gleich den niedrigen Stromwert sind. Im statischen Zustand ohne Eingangssignal fließt somit in der Serienschaltung der beiden Transistoren tp, tn der Referenzstrom ir. Ferner sind die W/L-Verhältnisse der beiden jeweils einander parallelgeschalteten Steuertransistoren ts1, ts1' ; ts2, ts2' des ersten bzw. zweiten Stromspiegels s1, s2 untereinander gleich.

Das Gate des n-Kanal-Transistors tn bzw. das des p-Kanal-Transistors tp ist nach Fig. 1 über den ersten bzw. zweiten Widerstand r1, r2 mit dem Steuereingang des ersten bzw. zweiten Stromspiegels s1, s2 verbunden und somit auch mit dem Ausgang des dritten bzw. des Referenzstromspiegels.

In Ausgestaltung der Erfindung ist der erste Widerstand r1 bzw. der zweite Widerstand r2 vom weiteren n-Kanal- bzw. weiteren p-Kanal-Transistor tr1, tr2 gebildet, deren gesteuerter Strompfad die Verbindung zwischen Gate des ersten bzw. zweiten Transistor tn, tp und dem ersten bzw. zweiten Stromspiegel s1, s2 ist und deren Gate am positiven bzw. negativen Pol vd, vs der Betriebsspannungquelle liegt.

In Weiterbildung der Erfindung kann dem Strompfad der weiteren Transistoren tr1, tr2 der Strompfad eines Paralleltransistors tr1', tr2' gleichen Leitungstyps parallelgeschaltet sein, wobei dem Gate des n-Kanal-Paralleltransistors tr1' das differenzierte Ausgangssignal v1 bzw dem Gate des p-Kanal-Paralleltransistors tr2' das invertierte differenzierte Ausgangssignal v̄1 zugeführt ist und die Differenzier-Zeitkonstante kleiner als die zu verarbeitende Impulsdauer des Eingangsgnals ist. Durch diese Weiterbildung wird insbesondere bei hohen Eingangssignalfrequenzen (10 MHz bis 20 MHz) erreicht, daß der statische Arbeitspunkt des Inverters sich schneller wieder einstellt als dies bei alleinigem Vorhandensein der weiteren Transistoren tr1, tr2 der Fall wäre.

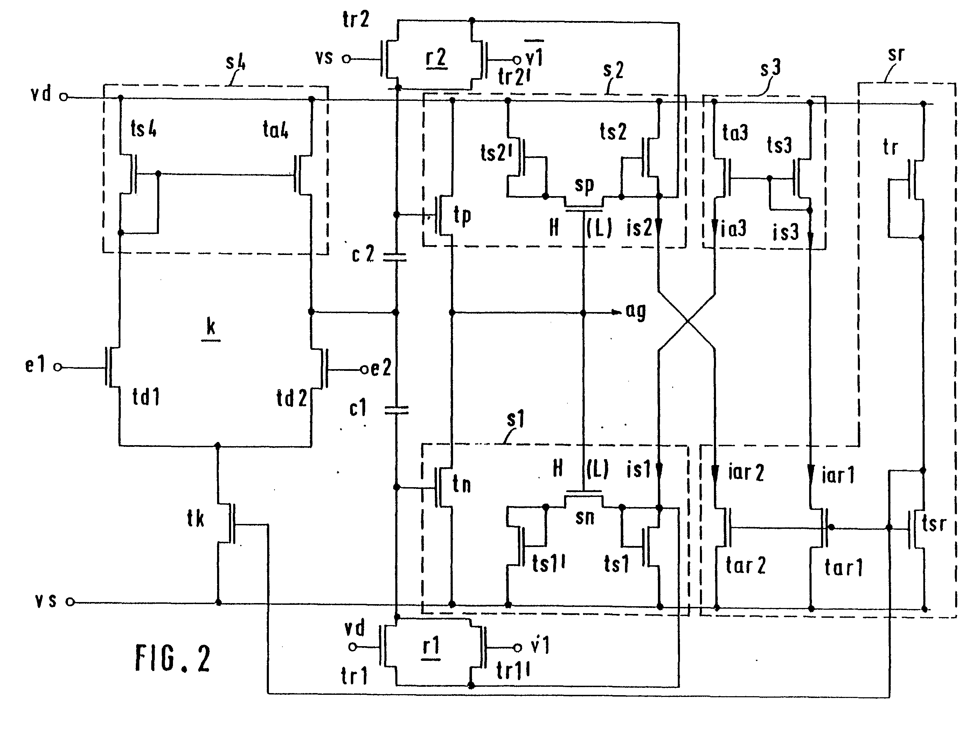

Die Fig. 2 zeigt das Schaltbild der erwähnten bevorzugten Verwendung des Inverters nach Fig. 1 zusammen mit dem Spannungskomparator-Differenzverstärker k. Dieser besteht aus den Differenzverstärkertransistoren td1, td2 deren Sourceanschlüsse über den als Konstantstromquelle betriebenen gemeinsamen Transistor tk am Pol vs der Betriebsspannungsquelle liegen, dessen Gate an den untereinander verbundenen Gates der Transistoren der Referenzstromquelle sr angeschlossen ist. Das Gate des Differenzverstärkertransistors td1 bildet den ersten Komparatoreingang e1 und das des Differenzverstärkertransistors td2 dessen zweiten Eingang e2. Die beiden Arbeitswiderstände des Differenzverstärkers werden vom Steuertransistor ts4 und vom Ausgangstransistors ta4 des vierten Stromspiegels s4 gebildet, wobei der gesteuerte Strompfad des Steuertransistors ts4 mit dem des Differenzverstärkertransistors td1 und der gesteuerte Strompfad des Ausgangstransistors ta4 mit dem des Differenzverstärkertransistors td2 in Reihe liegt und der Ausgang vom Verbindungspunkt der beiden letztgenannten Transistoren ta4, td2 gebildet wird und in Fig. 2 mit den beiden Kondensatoren c1, c2 verbunden ist.

An den beiden Eingängen e1, e2 auftretende unterschiedliche Spannungsdifferenzen bewirken für die beiden möglichen Signalflanken nur geringfügige unterschiedliche Signallaufzeiten. Dies ist insbesondere dann wichtig, wenn eine Anordnung nach Fig. 2 bei Frequenzen zwischen 10 und 20 MHz als Wandler betrieben werden soll, der ein digitales Tristate-Signal in ein Binärsignal wandelt.

## Patentansprüche

1. In CMOS-Technik realisierter Inverter mit zwei Transistoren, nämlich einem p-Kanal- und einem n-Kanal-Transistor (tp, tn), wobei

— deren gesteuerte Strompfade zwischen dem positiven (vd) und dem negativen (vs) Pol einer Betriebsspannungsquelle in Serie liegen und deren gemeinsamer Verbindungspunkt den Inverterausgang (ag) bildet,

— das Gate des n-Kanal-Transistors (tn) über einen ersten Kondensator (c1) mit dem Invertereingang (e) verbunden ist und

— der n-Kanal-Transistor (tn) der Ausgangstransistors eines ersten Stromspiegels (s1) ist, gekennzeichnet durch folgende Merkmale :

— das Gate des p-Kanal-Transistors (tp) ist über einen zweiten Kondensator (c2) mit dem Invertereingang (e) verbunden,

— der p-Kanal-Transistor (tp) ist der Ausgangstransistor eines zweiten Stromspiegels (s2),

— der jeweilige Ausgangsstrom des ersten bzw. zweiten Stromspiegels (s1, s2) ist in Abhängigkeit von den beiden Ausgangspegeln (H, L) des Inverters zwischen einem hohen und einem niedrigen Stromwert dadurch umgeschaltet, daß zwei hinsichtlich ihres Kanal-Längen/Breiten-Verhältnisses entsprechend bemessene Steuertransistoren (ts1, ts1' ; ts2, ts2') in jedem Stromspiegel über einen mit dem Gate am Inverterausgang (ag) liegenden Schalttransistor (sp, sn) miteinander verbunden sind,

— der Steuerstrom (is1) des ersten Stromspiegels (s1) ist der Ausgangsstrom (ia3) eines dritten Stromspiegels (s3) und der Steuerstrom (is3) des letzteren der erste Ausgangsstrom (iar1) eines Referenzstromspiegels (sr),

— der Steuerstrom (is2) des zweiten Stromspiegels (s2) ist der zweite Ausgangsstrom (iar2) des Referenzstromspiegels (sr), und

— das Gate des n-Kanal-Transistors (tn) bzw. des p-Kanal-Transistors (tp) ist über einen ersten bzw. zweiten Widerstand (r1, r2) mit dem Steuereingang des ersten bzw. des zweiten Stromspiegels (s1, s2) verbunden.

2. Inverter nach Anspruch 1, dadurch gekennzeichnet, daß der hohe Stromwert des ersten bzw. des zweiten Stromspiegels (s1, s2) gleich dem Doppelten seines niedrigen Stromwertes ist und daß alle Ströme der übrigen Stromspiegel (s3, sr) gleich dem niedrigen Stromwert sind.

3. Inverter nach Anspruch 1 oder 2, dadurch gekennzeichnet, daß der erste Widerstand (r1) bzw. zweite Widerstand (r2) von einem weiteren n-Kanal- bzw. einem weiteren p-Kanal-Transistor (tr1, tr2) gebildet ist, deren gesteuerter Strompfad die Verbindung zwischen Gate des ersten bzw. zweiten Transistors (tn, tp) und dem ersten bzw. zweiten Stromspiegel (s1, s2) ist und deren Gate am positiven bzw. negativen Pol (vs, vd) der Betriebsspannungsquelle liegt.

4. Inverter nach Anspruch 3, dadurch gekennzeichnet, daß dem Strompfad der weiteren Transistoren (tr1, tr2) der Strompfad eines Paralleltransistors (tr1', tr2') gleichen Leitungstyps parallelgeschaltet ist, daß dem Gate des n-Kanal-Paralleltransistors (tr1') das differenzierte Ausgangssignal (v1) bzw. dem Gate des p-Kanal-Paralleltransistors (tr2') das invertierte differenzierte Ausgangssignal ($\overline{v1}$) zugeführt ist und daß die Differenzier-Zeitkonstante kleiner als die zu verarbeitende Impulsdauer des Eingangssignals ist.

5. Verwendung eines Inverters nach einem der Ansprüche 1 bis 4, als Ausgangsstufe eines Spannungskomparator-Differenzverstärkers (k).

## Claims

1. Inverter implemented in CMOS technology and comprising two transistors, namely a p-channel transistor (tp) and an n-channel transistor (tn), with

— the controlled current paths of said transistors connected in series between the positive terminal (vd) and the negative terminal (vs) of a supply-voltage source and their junction point forming the inverter output (ag),

— the gate of the n-channel transistor (tn) connected to the inverter input (e) through a first capacitor (c1), and

— the n-channel transistor (tn) being the output transistor of a first current mirror (s1), characterized by the following features :

— The gate of the p-channel transistor (tp) is connected to the inverter input (e) through a second capacitor (c2),

— the p-channel transistor (tp) is the output transistor of a second current mirror (s2) ;

— the output current of the first current mirror (s1) and that of the second current mirror (s2) are switched between a high and a low current value depending on the two output levels (H, L) of the inverter, in that two transistors (ts1, ts1' ; ts2, ts2') in each current mirror which have respectively dimensioned channel-width-to-length ratios (= w/l ratio), are connected together with a switching transistor (sp, sn) having its gate coupled to the inverter output (ag),

— the drive current (is1) for the first current mirror (s1) is the output current (ia3) of a third current mirror (s3), and the drive current (is3) for the latter is the first output current (iar1) of a reference current mirror (sr) ;

— the drive current (is2) for the second current mirror (s2) is the second output current (iar2) of the reference current mirror (sr), and

— the gate of the n-channel transistor (tn) is connected to the drive input of the first current mirror (s1) through a first resistor (r1), and the gate of the p-channel transistor (tp) is connected to the drive input of the second current mirror (s2) through a second resistor (r2).

2. An inverter as claimed in claim 1, characterized in that the high current value of the first and second current mirrors (s1, s2) is equal to twice the low current value of the respective current mirror, and that all currents of the other current mirrors (s3, sr) are equal to the low current value.

3. An inverter as claimed in claim 1 or 2, characterized in that the first resistor (r1) and the second resistor (r2) are formed by an additional n-channel transistor (tr1) and an additional p-channel transistor (tr2), respectively, the controlled current path of the additional n-channel transistor (tr1) being the connection between the gate of the first transistor (tn) and the first current mirror (s1), and that of the additional p-channel transistor (tr2) being the connection between the gate of the second transistor (tp) and the second current mirror (s2), and the gates of the two additional transistors being connected, respectively, to the positive terminal (vs) and the negative terminal (vd) of the supply-voltage source.

4. An inverter as claimed in claim 3, characterized in that the current path of each of the two additional transistors (tr1, tr2) is shunted by the current path of a parallel transistor (tr1', tr2') of the same conductivity type, that the differentiated output signal (v1) is applied to the gate of the n-channel parallel transistor (tr1'), and the inverted differentiated output signal ($\overline{v1}$) to the gate of the p-channel parallel transistor (tr2'), and that the differentiation time constant is shorter than the input-pulse duration to be processed.

5. Use of an inverter as claimed in any one of claims 1 to 4 as the output stage of a differential amplifier (k) serving as a voltage comparator.

## Revendications

1. Inverseur réalisé en technique CMOS, comprenant deux transistors, à savoir un transistor à canal P et un transistor à canal N (tp, tn), leurs trajets de courant commandés étant connectés en série entre les pôles positif (vd) et négatif (vs) d'une source de tension d'alimentation et leur point de liaison commun formant la sortie de l'inverseur (ag), la grille du transistor à canal N (tn) étant connectée à l'entrée de l'inverseur (e) par l'intermédiaire d'un premier condensateur (c1) et le transistor à canal N (tn) étant le transistor de sortie d'un premier miroir de courant (s1), caractérisé en ce que la grille du transistor à canal P (tp) est connectée à l'entrée de l'inverseur (e) par l'intermédiaire d'un second condensateur (c2), en ce que le transistor à canal P (tp) est le transistor de sortie d'un second miroir de courant (s2), en ce que le courant de sortie du premier et, respectivement, du second miroir de courant (s1, s2) est commuté en fonction des deux niveaux de sortie (H, L) de l'inverseur entre une valeur de courant supérieure et une valeur de courant inférieure, en ce que deux transistors de commande (ts1, ts1' ; ts2, ts2'), dimensionnés en conséquence sur le plan de leur rapport longueur/largeur de canal, sont reliés ensemble, dans chaque miroir de courant, par l'intermédiaire d'un transistor de commutation (sp, sn) dont la grille est connectée à la sortie d'inverseur (ag), le courant de commande (is1) du premier miroir de courant (s1) est le courant de sortie (ia3) d'un troisième miroir de courant (s3) et le courant de commande (is3) de ce dernier est le premier courant de sortie (iar1) d'un miroir de courant de référence (sr), en ce que le courant de commande (is2) du deuxième miroir de courant (s2) est le deuxième courant de sortie (iar2) du miroir de courant de référence (sr), et en ce que la grille du transistor à canal N (tn) et, respectivement, du transistor à canal P (tp) est connectée, par l'intermédiaire d'une première et, respectivement, d'une seconde résistance (r1, r2), à l'entrée de commande du premier et, respectivement, du deuxième miroir de courant (s1, s2).

2. Inverseur suivant la revendication 1, caractérisé en ce que la valeur de courant supérieure du premier et, respectivement, du second miroir de courant (s1, s2) est égale au double de sa valeur de courant inférieure, et en ce que tous les courants des autres miroirs de courant (s3, sr) sont égaux à la valeur de courant inférieure.

3. Inverseur suivant la revendication 1 ou 2, caractérisé en ce que la première résistance (r1) et, respectivement, la deuxième résistance (r2) est formée par un autre transistor à canal N et, respectivement, un autre transistor à canal P (tr1, tr2) dont le trajet de courant commandé est la liaison entre la grille du premier et, respectivement, du deuxième transistor (tn, tp) et le premier et, respectivement, le deuxième miroir de courant (s1, s2), et dont la grille est connectée au pôle positif et, respectivement, négatif (vs, vd) de la source de tension d'alimentation.

4. Inverseur suivant la revendication 3, caractérisé en ce que le trajet de courant d'un transistor parallèle (tr1', tr2') de même type de conductibilité est monté en parallèle au trajet de courant des autres transistors (tr1, tr2), en ce qu'à la grille du transistor parallèle à canal N (tr1') est envoyé le signal de sortie différencié (v1) et, respectivement, à la grille du transistor parallèle à canal P (tr2') est envoyé le signal de sortie différencié inversé ($\overline{v1}$), et en ce que la constante de temps de différenciation est inférieure à la durée d'impulsion à traiter du signal d'entrée.

5. Utilisation d'un inverseur, suivant l'une quelconque des revendications 1 à 4, comme étage de sortie d'un amplificateur différentiel de comparateur de tension (k).

FIG. 1

FIG.2